# EUROPÄISCHE PATENTSCHRIFT

(11) **EP 2 264 713 B1**
(45) Veröffentlichungstag und Bekanntmachung des Hinweises auf die Patenterteilung: **04.09.2013**
(21) Anmeldenummer: 10183351.5
(22) Anmeldetag: 07.01.2004
(51) Int. Cl.: G11C 11/22

(54) **Schneller remanenter resistiver ferroelektrischer Speicher**
Fast remanent resistive ferroelectric memory
Mémoire ferroélectrique resistive remanente à accès rapide

(30) Priorität: 28.01.2003 DE 10303316
(43) Veröffentlichungstag der Anmeldung: 22.12.2010
(62) Teilanmeldung aus: 04700445.2
(73) Patentinhaber: Forschungszentrum Jülich GmbH, 52425 Jülich (DE)
(72) Erfinder: Kohlstedt, Dr., Hermann, 52455 Jülich (DE); Meyer, Dr., René, 52074 Aachen (DE)
(74) Vertreter: Gille Hrabal

(56) Entgegenhaltungen:
- EP-A- 0 657 936
- WO-A-02/43071
- WO-A-02/45172
- US-A- 5 329 485
- US-A- 5 341 325
- US-A- 5 517 445
- US-A- 5 737 180
- US-A- 5 757 042
- US-A- 6 146 906
- US-A1- 2001 007 364
- US-A1- 2002 089 005
- US-B1- 6 344 991
- CONTRERAS J R ET AL: "Memory device based on a ferroelectric tunnel junction" IEEE CONFERENCE PROCEEDINGS, 24. Juni 2002 (2002-06-24), Seiten 97-98, XP010600828
- H. KOHLSTEDT, N.A. PERTSEV, R. WASER: "Size effects on polarization in epitaxial ferroelectric films and the concept of ferroelectric tunnel junctions including first results" MAT. RES. SOC. SYMP. PROCEEDINGS, 2002, Seiten 161-172, XP009029767 USA
- FLEISHER H ET AL: "STORAGE ELEMENT FOR MACHINE USE" IBM TECHNICAL DISCLOSURE BULLETIN, IBM CORP. NEW YORK, US, Bd. 14, Nr. 12, 1. Mai 1972 (1972-05-01), Seiten 3581-3582, XP002039943 ISSN: 0018-8689

## Beschreibung

Die Erfindung betrifft ein Verfahren zum elektronischen Speichern von Informationen sowie ein Speicherelement hierfür..

Derartige Speicher sind bekannt. Üblicherweise werden derzeit CMOS-basierte, wahlfreie Massenspeicher (SRAM/ DRAM) eingesetzt.

Nach Abschalten der Versorgungsspannung verliert ein SRAM-oder DRAM-Speicherelement seine Information. Zielsetzung ist die Bereitstellung von Speicherelementen, die auch nach Abschalten der Versorgungsspannung ihren Speicherinhalt behalten,

Unter wahlfreiem Massenspeicher ist zu verstehen, dass die Information nicht sequenziell aus einzelnen Speicherelementen ausgelesen werden muss, wie dies z, B, bei einer Festplatte der Fall ist, Es kann also in einem solchen Massenspeicher, der viele einzelne Speicherelemente aufweist ein ausgewähltes Speicherelement gezielt beschrieben und/ oder ausgelesen werden,

Um den Speicherinhalt auch nach Abschalten der Versorgungsspannung behalten zu können, werden sogenannte FLASH-Speicherelemente verwendet, Ein FLASH-Speicherelement umfasst einen CMOS-Transistor, Der Transistor weist ein sogenanntes FLOATING-Gate auf. Hierunter ist ein Gate zu verstehen, welches zunächst nicht elektrisch mit seiner Umgebung verbunden ist. Durch einen Tunnelprozess wird Ladung an das FLOATING-Gate weitergeleitet. Der Tunnelprozess wird durch Anlegen einer sehr hohen Spannung in Gang gesetzt. Anschließend kann die im FLOATING-Gate befindliche Ladung nicht mehr abfließen. Die Information bleibt also unabhängig davon gespeichert, ob eine Versorgungsspannung anliegt oder nicht.

Problematisch ist die hohe Spannung, Ferner dauert es relativ lange, bis ein FLASH-Speicherelement beschrieben ist. Die Zahl der Schreibzyklen ist relativ gering.

Zielsetzung ist, die Speicherfähigkeiten eines FLASH-Speicherelements mit den schnellen Lese- und Schrelbzeiten zu kombinieren, die beim eingangserwähnten SRAM-Speicherelement möglich sind.

Zur Erreichung dieses Ziels sind FeRAM sowie MRAM-Speicherelemente entwickelt worden.

Ein FeRAM-Speicherlelement ist wie folgt aufgebaut. Beispielsweise gibt es eine Schicht aus ferroelektrischem Material. Zu beiden Seiten wird diese Schicht mit Elektroden kontaktiert. Das ferroelektrische Material weist eine Polarisationsrichtung auf, die durch Anlegen einer Spannung an die Elektroden umgeklappt werden kann. Die Spannung muss hierfür geeignete Polarität und geeignete Größe aufweisen. Es wird also die Koerzitivspannung angelegt, um das Umklappen der Polarisation zu bewirken. Die Richtung der Polarisation entspricht der digital gespeicherten Information (0 oder 1).

Um die Information auszulesen, wird eine Spannung angelegt, die groß genug ist, um die Polarisationsrichtung umklappen zu lassen. Klappt die Polarisationsrichtung um, fließt kurzzeitig eine entsprechend große Ladung. Die Ladungsmenge wird durch Messen der Spannungsänderung über einen Kondensator bestimmt. Ist eine solche Spannungsänderung registriert worden, so wird damit festgestellt, dass die Polarisationsrichtung umgeklappt ist. Damit ist klar, dass der Polarisationszustand vor Anlegen der Spannung entsprechend umgekehrt vorlag. Fließt bei Anlegen entsprechender Spannung lediglich eine sehr kleine Ladungsmenge, so ist damit ermittelt worden, dass kein Umklappprozess statt gefunden hat. Damit ist ebenfalls die Polorisationsrichtung ermittelt und somit der gespeicherte Zustand ausgelesen worden,

Bei Verkleinerung der Fläche des FeRAM-Speicherelements verringert sich die Ladungsmenge, was zu Problemen bei der Miniaturisierung führt.

Wird beim Auslesen durch Anlegen einer Koerzitivspannung die Polarisation umgeklappt, ist damit die abgespeicherte Information geändert worden. In diesem Fall muss nach dem Auslesen der Information diese erneut in der entsprechenden Speicherzelle abgespeichert werden. Nachteilhaft kann bei einem FeRAM-Speicherelement der Speicherinhalt also nicht zerstörungsfrei ausgelesen werden.

Erneutes Einlesen einer Information kostet Zelt. Entsprechend werden Schreib- und Lesezeiten bei einem FeRAM-Speicherelement reduziert. Ferner wird Strom für das erneute Einschreiben benötigt. Dies Ist ebenfalls nachteilhaft.

Ein FeRAM-Speicherelement weist darüber hinaus den Nachteil auf, im Laufe der Zeit erstens eine gespeicherte Information zu verlieren und zweitens überhaupt die Fähigkeit zu verlieren, Informationen zu speichern.

Um ein schnelles Speicherelement bereit zu stellen, weiches nach Abschalten der Versorgungsspannung seine Information behält, gibt es darüber hinaus sogenannte MRAM-Speicherelemente. Bei einem MRAM-Speicherelement ist eine hartmagnetische Schicht mit vorgegebener Magnetisierungsrichtung durch einen Tunnelkontakt von einer weichmagnetischen Schicht getrennt. Die Magnetisierungsrichtung der weichmagnetischen Schicht kann durch Anlegen eines geeigneten magnetischen Feldes umgeklappt werden. Das Magnetfeld wird durch einen elektrischen Strom erzeugt. Der elektrische Widerstand des Tunnelkontakts hängt davon ab, ob die Magnetisierungsrichtung In der weichmagnetischen Schicht parallel oder antiparallel zur Magnetisierungsrichtung In der hartmognetischen Schicht steht. Die Information wird also durch Ermittlung eines elektrischen Widerstandes ausgelesen, der durch den Tunnelkontakt gebildet wird. Ein MRAM-Speicherelement ist daher ein sogenanntes resistives Spelcherelement. Der Informationsgehalt wird durch Ermittlung eines elektrischen Widerstandes ermittelt. Hiervon zu unterscheiden sind die vorgenannten Speicherelemente, zum Beispiel das FeRAM-Speicherelement. Hierbei handelt es sich um ein so genanntes ladungsbasiertes Speicherelement.

Resistive Speicherelemente sind ladungsbasierten Speicherelementen grundsätzlich überlegen, So können resistive Speicherelemente einfacher miniaturisiert werden.

Nachteilhaft tritt bei einem MRAM-Speicherelement ein deutliches Übersprechen beim Einschreiben der Information auf. Hierunter ist zu verstehen, dass bei Einschreiben einer Information benachbarte Speicherelemente in einem Massespeicher beeinflusst werden und möglicherweise hier unerwünscht Information geändert wird. Nachteilhaft ist, dass ein Tunnelkontakt erzeugt werden muss, der relativ große Produktionskosten verursacht. Mit Zunahme der Schaltzyklen kommt es zu einer unerwünschten Drehung der Magnetisierung im Hartmogneten Dies führt zum Ausfall der Speicherzelle.

Ein bekanntes Speicherelement mit mehreren permanenten Schaltzuständen (EP 0 657 936 A1) weist zwischen zwei Elektroden eine nicht leitende dielektrische Schicht sowie eine weitere Schicht aus bei Raumtemperatur ferroelektrischem Material permanenter Polarisation auf. Mit Hilfe von Spannungsimpulsen lässt sich der Speicherzustand des Speicherelements ändern. Das Speicherelement wird durch Strommessung ausgelesen.

Weiterhin ist es zum elektronischen Speichern von Informationen bekannt (WO 02/451 72 A1), die Informationen durch Ausrichten der Polarisation einer polarisierbaren Schicht in ein Speicherelement zu schreiben und die eingeschriebene bzw. gespeicherte Information mittels einer Strom-Spannungs-Kennlinie nicht destruktiv auszulesen.

Schließlich ist auch ein ferroelektrisches Speicherelement mit Elektrode und Gegenelektrode bekannt (WO 02/43071 A1), wobei an die Elektrode eine ferroelektrische Schicht angrenzt, an welche eine Schicht aus nicht-ferroelektrischem Material angrenzt.

Aufgabe der Erfindung ist, digitale Informationen schnell remanent speichern sowie aus dem Speicher auch schnell auslesen zu können.

Diese Aufgabe wird durch ein Verfahren mit den Merkmalen des Anspruchs 1 gelöst. Außerdem wird diese Aufgabe durch ein Speicherelemente mit den Merkmalen des Anspruchs 3 gelöst.

Vorteilhafte Ausgestaltungen ergeben sich aus den jeweiligen Unteransprüchen.

Das Speicherelement der erfindungsgemäßen Art wird von beiden Seiten von einer Elektrode kontaktiert. Das Speicherelement umfasst wenigstens eine ferroelektrische Schicht und eine daran angrenzende nicht-ferroelektrische Schicht. Eine Elektrode kontaktiert die ferroelektrische Schicht und die andere Elektrode die nicht-ferroelektrische Schicht. Anstelle der nicht-ferroelektrischen Schicht kann auch eine hinreichend schwach ferroelektrische Schicht verwendet werden, um die erfindungsgemäße Wirkung zu erzielen.

Die Information wird geschrieben, indem die Polarisationsrichtung in der ferroelektrischen Schicht in die entsprechende Richtung geklappt wird. Die eine Polarisationsrichtung entspricht der "1"-Information, die andere Polarisationsrichtung der "0"-Information,

Die Polarisationsrichtung wird in die gewünschte Richtung geklappt, indem Spannung an beide Elektroden angelegt wird, die hierfür geeignet groß ist und die gewünschte Richtung aufweist.

Die dotierten leitfähigen Oxyde oder dotierten Halbleiter der nicht-ferroelektrischen Schicht reduzieren den elektrischen Widerstand des erfindungsgemäßen Speicherelements, wodurch die gespeicherten Informationen mit hohen Taktfrequenzen eingeschrieben und auch ausgelesen werden können.

Da die Information geschrieben wird, indem eine Spannung angelegt wird, tritt nicht das Problem des Übersprechens wie beim MRAM-Speicherelement auf.

Der elektrische Widerstand, der von der nicht-ferroelektrischen und der ferroelektrischen Schicht gebildet wird, hängt von der Polarisationsrichtung in der ferroelektrischen Schicht ab. Zum Auslesen des Speicherelementes wird an die Elektroden z. B. eine Spannung angelegt und der Stromfluss gemessen. Der so oder anders ermittelte elektrische Widerstand stellt ein Maß für die Polorisationsrichtung und damit ein Maß für die abgespeicherte Information dar.

Im Unterschied zu FeRAM-Speicherelementen wird die Information resistiv und damit zerstörungsfrei ausgelesen. Die Information bleibt auch nach dem Auslesen erhalten. Eine ausgelesene Information braucht nicht erneut abgespeichert zu werden. Hieraus ergeben sich gegenüber einem FeRAM-Speicherelement Geschwindigkeitsvorteile.

Wird das erfindungsgemäße Speicherelement verkleinert, so veändert sich zwar der Widerstand. Es kann jedoch beim erfindungsgemäßen Bauelement durch Veränderung der Leitfähigkeit der verwendeten Materialien und/oder die Wahl geeigneter Elektroden der Widerstand bei Verkleinerung des Speicherelements so angepasst werden, dass der Widerstandsunterschied in Abhängigkeit von der Polarisationsrichtung ermittelt werden kann. Eine Verkleinerung der Bauelemente der erfindungsgemäßen Art ist also im Vergleich zu FeRAM-Speicherelementen unproblematisch möglich.

Unproblematisch kann die Widerstandsänderung, die mit einer Änderung der Polarisationsrichtung im ferroelektrischen Material verbunden ist, den Faktor 2 und mehr betragen. Es ist sogar möglich, Widerstandsänderungen zu erzielen, die sich um das 10-bis 100-fache und mehr unterscheiden. Es bereitet daher keine Probleme, eine Information auszulesen.

Es hat sich ferner herausgestellt, das bautechnische Störeinflüsse bei FeRAM-Speicherelementen beim erfindungsgemäßen Speicherelement nicht auftreten bzw, sogar positiv genutzt werden.

Um das erfindungsgemäße Speicherelement bei hohen Frequenzen betreiben zu können, ist ein kleiner elektrischer Widerstand erforderlich. Es ist daher im Unterschied zu FeRAM-Speicherelementen hier von Vorteil, wenn der elektrische Widerstand der ferroelektrischen und nicht-ferroelektrischen Schicht klein ist. Ein elektrischer Widerstand im Sinne der Erfindung ist klein, wenn mit hohen Taktfrequenzen ausgelesen werden kann. Die möglichen Taktfrequenzen liegen dann insbesondere bei 100 MHz und mehr. Mit anderen Worten: Ist es nicht möglich, ein erfindungsgemäßes Speicherelement mit Frequenzen oberhalb von 100 MHz auszulesen, so liegt kein kleiner Widerstand im Sinne der Erfindung vor.

Als Materialien für die Bereitstellung der ferroelektrischen Schicht werden ferroelektrische Anorganika, insbesondere Oxyde mit Perowskit- oder perowskitähnlichen Struktur oder ferroelektrische Polymere bevorzugt. Möglich sind ferner ferroelektrische Flüssigkristalle. Soll ein Speicherelement der erfindungsgemäßen Art besonders preiswert bereit gestellt werden, so werden ferroelektrische Polymere bevorzugt. Soll ein erfindungsgemäßes Speicherelement bereit gestellt werden, welches besonders schnell ist, also bei dem besonders schnell Informationen eingeschrieben und/ oder ausgelesen werden können, so werden ferroelektrische Oxyde bevorzugt. Beispiele für besonders vorteilhafte ferroelektrische Oxyde sind PbZrₓTi₁₋ₓO₃, Ba₁₋ₓSrₓTiO₃ wie BaTiO₃, SrBi₂Ta₂O₉, KₓWO₃ sowie Bi₄Ti₃O₁₂. Um zu einer besonders guten Langzeitstabilltöt zu gelangen, werden PbZrₓTi₁₋ₓO₃ sowie SrBi₂Ta₂O₉ besonders bevorzugt. Beispiele für besonders vorteilhafte ferroelektrische Polymere sind PVDF, PVDF-TFE, [CH₂CF₂]ₙ. PVDF ist besonders zu bevorzugen. Hieraus lassen sich besonders gut Speicher für flexible Anwendungen, z. B. biegsame Chipkarten oder Smartcards, herstellen.

Sollen ganz besonders schnelle Speicherelemente der erfindungsgemäßem Art bereit gestellt werden, so wird als Material für die ferroelektrische Schicht sogenannte Nieder- ∈ - Ferroelektrika gewählt. Die Dielektrizitätskonstante ∈ ist klein, wenn ∈ kleiner als 100 ist.

Als ferroelektrische Materialien eignen sich Verbindungen mit einer Perowskit- oder perowskitähnllchen Struktur, wie z.B.,

| | |
|---|---|
| PbZrₓTi₁₋ₓO₃ (PZT) | *Beispiel für besonders gute Langzeitstabilität |
| SrBi₂Ta₂O₉ (SBT) | *Beispiel für besonders gute Langzeitstabilität |
| Ba₁₋ₓSrₓTiO₃ | |
| Ba₁₋ₓPbₓTiO₃ | |

ferroelektrische Niobat-Kristalle der Formel PbNb₂O₆,
ferroelektrische Kristalle mit Wolfram-Bronze Struktur der Formel KₓWO₃ und NaₓWO₃ mit x <1,
ferroelektrische Kristalle wie z.B. Bi₄Ti₃O₁₂, Gd₂(MoO₄), Pb₅Ge₃O₁₁ oder Verbindungen der KTiOPO₄-Famille oder
ferroelektrische Halbleiter (SbSI-Familie) sowie organische Ferroelektrika, beispielweise Polymere:
Polyvinyliden Fluoride (PVDF)
Polyvinyliden Fluorid-Trifluoroethylene (PVDF-TFE)
Cynopolymere
Ungeradzahlige Nylons
(CH₂CF₂)ₙ mit n > = 1
wasserlösliche ferroelektrische Kristalle der KH₂PO₄- Familie (KDP) oder
(NH₂CH₂COOH)₃ x H₂SO₄ - Familie (TGS),

### Als nicht-ferroelektrische Materialien eignen sich z.B.:

### Leitende Polymere:

Dotierte Polypyrrole (PPy)
Dotierte Polyaniline
Dotierte Polythionphene, z.B. PEDOT (Poly(3,4-Ethylen Dioxythiophenen)

### Leitende Oxyde:

IrOₓ, RuOₓ, Halbleiter, insbesondere Si, TaₓO_{y}, Si₃N₄, Ti₃N₄, a-Si, SrOₓ, SrRuO₃, LaNiO₃, La₁₋ₓSrₓCoO₃, La₁₋ₓCaₓMnO₃, La_{1-x-y}SrₓCa_{y}MnO₃, LaCo₁₋ₓMnₓO₃

Vorteilhaft ist eine Dotierung der nicht-ferroelektrischen Schicht. Als nicht-ferroelektrisches Material, welches elektrisch leitend ist, werden im Fall eines preiswerten Bauelementes bevorzugt Polymere wie PPy oder PEDOT vorgesehen. PPy ist besonders vorteilhaft, weil es zu einer höheren Kristallinität der ferroelektrischen Schicht führt. Dadurch werden höhere Werte der ferroelektrischen Polarisation erreicht.

Wenn ein besonders schnelles Bauelement bzw. Speicherelement der erfindungsgemäßen Art bereit gestellt werden soll, wird als nicht-ferroelektrisches Material dotiertes SrTiO₃ bevorzugt. Als Dotiermaterial sind besonders gut La, Nb geeignet.
Die nicht-ferroelektrische Schicht sollte in einer Ausführungsform der Erfindung wenigstens 1 Å dick sein. Besonders bevorzugt sind Dicken von wenigstens einem Nanometer. Dicken oberhalb von 20 nm können von Vorteil sein. Die ferroelektrische Schicht sollte wenigstens einen Nanometer dick sein. Besonders bevorzugt sind Dicken von wenigstens 1 0 Nanometer. Das gesamte Speicherelement ohne die Elektroden sollte Insgesamt nicht dicker als 5 µm, besonders bevorzugt nicht dicker als 500 Nanometer, ganz besonders bevorzugt nicht dicker als 200 Nanometer sein.

Je dünner die nicht-ferroelektrische Schicht ist, desto kleiner Ist die Widerstandsänderung, die durch Umklappen der Polarisation herbeigeführt wird. Andererseits sind zugleich entsprechend schnellere Auslesezeiten möglich. Soll also ein Speicherelement der erfindungsgemäßen Art bereit gestellt werden, bei dem besonders schnelle Auslesezeiten möglich sind, so ist die nicht-ferroelektrische Schicht relativ dünn. Eine nicht-ferroelektrische Schicht ist Insbesondere dann dünn, wenn diese dünner ist als die ferroelektrische Schicht. Sie ist ferner dünn, wenn die Dicke weniger als 30 Nanometer, bevorzugt weniger als 5 Nanometer beträgt. Besonders bevorzugt ist die nicht ferroelektrische Schicht wenigstens zweifach dünner als die ferroelektrische Schicht.

Bei der ferroelektrischen Schicht verhält es sich ähnlich, Je dünner die ferroelektrische Schicht ist, desto kleiner ist die damit verbundene Widerstandsänderung, die durch Umklappen der Polarisation herbeigeführt wird. Jedoch sind mit kleineren ferroelektrischen Schichtdicken schnellere Auslesezeiten möglich. Soll also ein Bauelement bzw. Speicherelement mit besonders schnellen Auslesezeiten bereit gestellt werden, so ist die Schichtdicke der ferroelektrischen Schicht klein. Eine Schichtdicke der ferroelektrischen Schicht ist insbesondere klein, wenn der Wert von 30 Nanometern unterschritten wird. Die Schichtdicke ist ferner insbesondere dann klein, wenn diese kleiner ist als die Schichtdicke der nicht-ferroelektrischen Schicht.

In einer weiteren Ausführungsform sind sowohl die ferroelektrische als auch die nicht ferroelektrische Schicht dünn.

Große Widerstandsänderungen sind von Interesse, wenn die Information besonders zuverlässig auslesbar sein soll, das Bauelement innerhalb großer Temperaturbereiche einsetzbar und/ oder gegenüber Strahlung unempfindlich sein soll.

In einer weiteren Ausführungsform der Erfindung wird die ferroelektrische Schicht beidseitig von einer nicht-ferroelektrischen Schicht kontaktiert. In diesem Fall ist eine Mindestspannung erforderlich, damit eine Widerstandsänderung beim Umklappen der Polarisation eintritt. Aufgrund der Mindestspannung, die erforderlich ist, wenn beidseitig nicht-ferroelektrisch leitende Schichten vorgesehen werden, ist die erstgenannte Ausführungsform jedoch zu bevorzugen.

Als Material der Elektroden sind solche Materialien zu bevorzugen, die einen geringeren Kontaktwiderstand mit den angrenzenden Schichten des Speicherelements aufweisen. Geringe Kontaktwiderstände können durch ein geringes Kontaktpotential oder durch einen Tunnelkontakt bereitgestellt werden. Ein Kontaktpotential ist gering wenn die Austrittsarbeit des Materials der Elektrode, die insbesondere aus einem Metall bestehen kann, und die Elektronenaffinität der Schicht um weniger als 0,5 Elektronenvolt differiert. Viele Metalle weisen eine geeignete Austrittsarbeit auf. Daneben kommen elektrisch leitende oxydische Elektroden in Betracht. Oxydische Elektroden sind vorteilhaft, weil die Leitfähigkeit des Kontaktes/der Kontakte besser eingestellt werden kann. Durch die Einstellung können die gewünschten Eigenschaften des Speicherelementes bereit gestellt werden. Oxydische Elektroden werden dann bevorzugt, wenn diese an Oxyde angrenzen,

Das erfindungsgemäße Bauelement ist in einer Ausführungsform auf einem Substrat aufgebracht. Auf dem Substrat befindet sich dann die untere Elektrode. Hieran grenzt zunächst die ferroelektrische Schicht und darüber die nicht-ferroelektrische Schicht (oder umgekehrt) an. Darüber befindet sich die sogenannte TOP-Elektrode. Diese besteht zweckmäßigerweise aus Metall, da die Fertigung dann besonders einfach ist. Die untere Elektrode, auch BOTTOM-Elektrode genannt, besteht zweckmäßigerweise aus oxydischem Material. Diese kann jedoch auch aus Metall bestehen.

In einer weiteren Ausführungsform der Erfindung wird bevorzugt die TOP-Elektrode von einer nicht-ferroelektrischen Schicht begrenzt. Dies eröffnet relativ große Wahlmöglichkeiten in Bezug auf die eingesetzten Materialien. So kann auf den jeweiligen Anwendungsfall abgestimmt ein Speicherelement mit entsprechend optimierten Eigenschaften bereitgestellt werden.

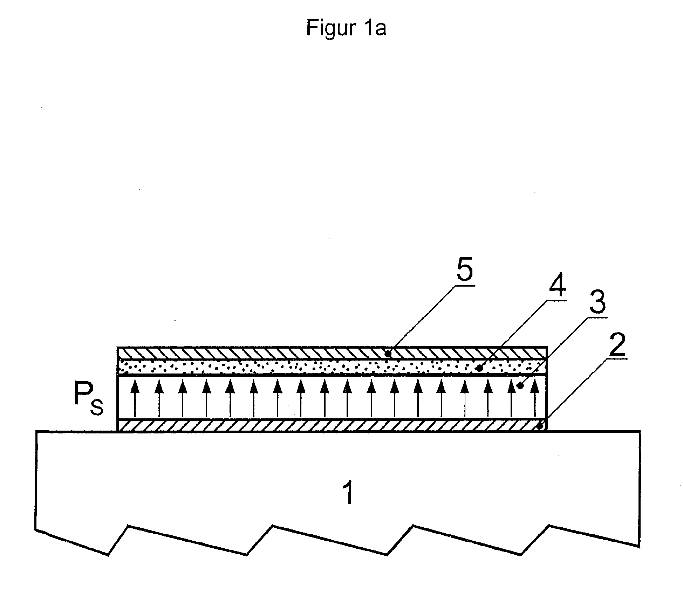

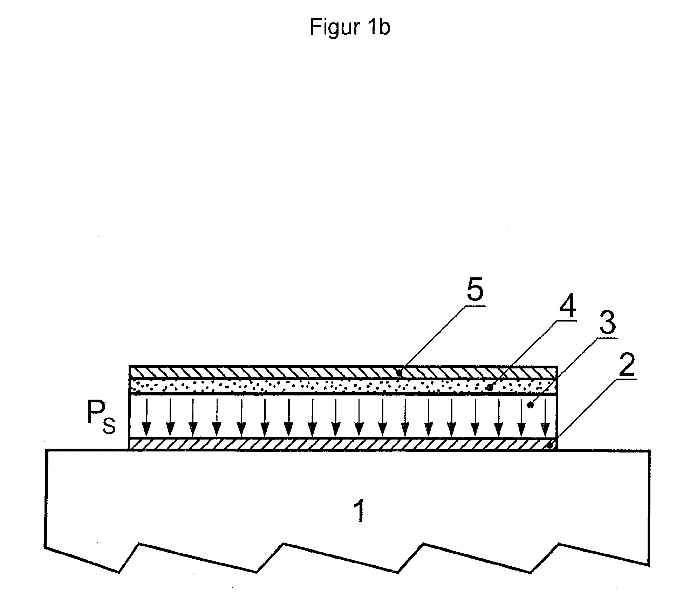

In diesem Fall (Figur 1) kann die nicht- (oder schwach-) ferroelektrische Schicht kalt abgeschieden werden. Es ist also möglich, halbleitende Materialien wie z.B. dotiertes Silizium abzuscheiden. Falls die nicht-ferroelektrische Schicht an die Topelektrode angrenzt, werden dadurch die Aufwachsbedingungen für die ferroelektrische Schicht nicht negativ beeinflusst.

Bei der Verwendung von polymeren ist es von Vorteil, wenn die ferroelektrische Schicht an die Topelektiode angrenzt. In diesem Fall wird das ferroelektrische Polymer auf das nicht-ferroelektrische Polymer aufgebracht, wodurch die Kristallinität der ferroelektrischen Schicht erhöht wird. Dies verbessert die ferroelektrischen Eigenschaften.

In einer vorteilhaften Ausgestaltung der Erfindung sind die nicht-ferroelektrische Schicht und/oder die ferroelektrische Schicht dotiert. Hierdurch wird die Leitfähigkeit eingeteilt und die Langzeitstabilität des erfindungsgemäßen Bauelements gesteigert.

Die ferroelektrische Schicht ist im Fall von Oxyden bevorzugt einkrlstallin oder kolumnar. Sie kann jedoch auch polykristallin sein. Werden Polymere eingesetzt, so ist eine polykrlstalline Struktur zu bevorzugen. Folgende Vorteile werden durch die Wahl der jeweiligen Struktur erzielt. In Oxyden ist die Herstellung kolumnarer Schichten mit hoher remanter Polarisation einfacher als die Herstellung einkristaliner Schichten (besonders kostengünstig). Weiterhin lässt sich über die Mikrostruktur das Schaltverhalten und der Wert der remanenten Polarisation beeinflussen.

Wird die Polarisation in der ferroelektrischen Schicht nur teilweise umgeschaltet, so können nicht nur "0" oder "1" Informationen abgespeichert werden, sondern auch Zwischenzustände. Die Speicherdichte erhöht sich entsprechend Vorteilhaft sind kolumnare Schichten vorzusehen. Eine kolumnare Schicht ist also zu bevorzugen, wenn eine besonders hohe Speicherdichte bereit gestellt werden soll. Es handelt sich um ein säulenartige Struktur, bei denen die Säulen von einer Elektrode in Richtung der anderen Elektrode weisen. Jede Säule ist einkristallin aufgebaut. Zwischen den einzelnen Säulen existiert beispielsweise eine kristallographische Versetzung.

Um die verschiedenen unterschiedlichen Polarisationszustände zwecks Erzielung einer großen Speicherdichte zu erreichen, ist es erforderlich, eine definierte Ladungsmenge für das Schreiben vorzusehen. Er wird also Strom in definierter Menge zugeführt.

Vorteile unterschiedlicher Dotierungen:
Schwach dotiert: hohe Widerstandsänderung, hoher Widerstand -> besonders sicher und stromsparend
Hoch dotiert: geringer Widerstand, kleinere Widerstandsänderung - > sehr schnell, stark miniaturisierbar

Bei oxydischen Schichten ist eine Dotierung mit Donatoren besonders geeignet, da diese die Dichte von schwach beweglichen Gitterfehlstellen im Oxyd verringert, wodurch die Zyklenzahl und die Langzeitstabilität des Speicherelements deutlich verbessert wird.

Als leitende nicht-ferroelektrische Schicht ist donatordotiertes Strontiumtitanat (n-STO) in Kombination mit PZT/ SBT geeignet, da es eine geringe Gitterfehlanpossung zu PZT oder SBT aufweist und bei der Herstellung keine störenden Fremdphasen an der Grenzfläche zur ferroelektrischen Schicht entstehen. Als Dotierstoffe sind Lanthanoide sowie Nb und V denkbar.

Besonders günstige Donatoren sind aufgrund ihrer Valenzstabilität La und Nb.

Die ferroelektrische Schicht ist bevorzugt dicker als die nicht ferroelektrische Schicht, wenn große Widerstandsänderungen aus vorgenannten Gründen erwünscht sind. Die Speicherung und das Auslesen von Information gelingt so besonders zuverlässig.

### Ausführungsbeispiel

In der Figur 1a,b wird im Schnitt ein Substrat 1 gezeigt, auf dem sich eine Bottom-Elektrode 2 befindet. Diese besteht aus einem elektrisch leitenden, oxydischen Material. Auf der Bottom-Elektrode ist eine kolumnare Schicht 3 aus ferroelektrischem Material aufgebracht. Hierüber befindet sich eine Schicht 4 aus nicht ferroelektrischem Material. Zuletzt endet der Aufbau des Speicherelements mit der Top-Elektrode 5.

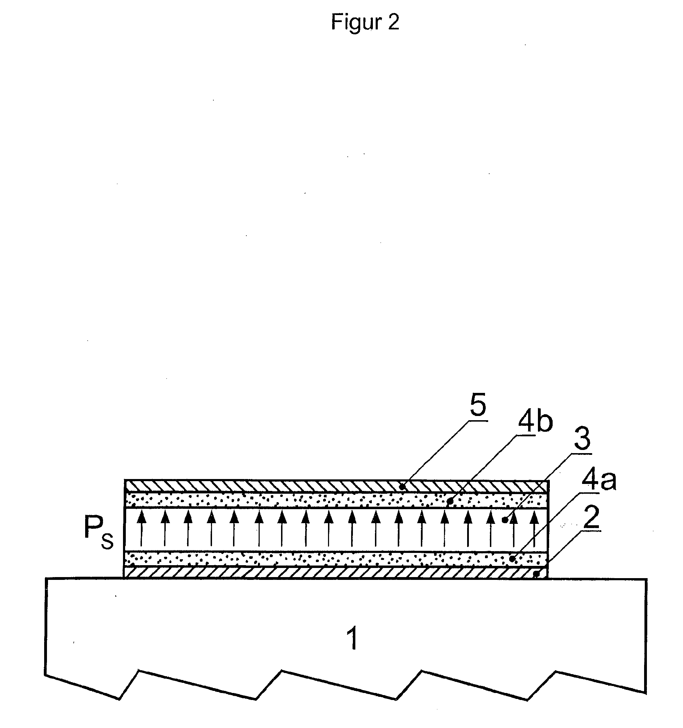

Fig. 2 zeigt ein weiteres Ausführungsbeispiel mit zwei nicht ferroelektrischen Schichten 4a und 4b.

## Patentansprüche

1. Verfahren zum elektronischen Speichern von Informationen, bei dem In ein Speicherelement, bestehend aus einer Elektrode (2), einer hieran angrenzenden ferroelektrischen Schicht (3), einer an die ferroelektrische Schicht (3) angrenzenden Schicht (4) aus nicht ferroelektrischem Material sowie einer an die nicht-ferroelektrische Schicht angrenzenden Elektrode (5), eine Information durch Ausrichten der Polarisation der ferroelektrischen Schicht In diese Schicht geschrieben und die Information gelesen wird, indem die Polarisationsrichtung durch eine Widerstandsmessung ermittelt wird, **dadurch gekennzeichnet, dass** die nicht-ferrolektrische Schicht (4) ein dotiertes elektrisch leitfähiges Oxyd oder einen dotierten Halbleiter aufweist.

2. Verfahren nach Anspruch 1, **dadurch gekennzeichnet, dass** die nichtferroelektische Schicht (4) des Speicherelementes dotiertes SrTiO₃ aufweist.

3. Speicherelement zum Durchführen des Verfahrens nach einem der Anspruch 1 oder 2, mit einer Elektrode (2), einer hieran angrenzenden ferroelektrischen Schicht (3), einer an die ferroelektrische Schicht (3) angrenzenden Schicht (4) aus nicht ferroelektrischem Material sowie einer an die nicht-ferroelektrische Schicht angrenzenden Elektrode (5), wobei der von der nicht-ferroelektrischen und der ferroelektrischen Schicht gebildete elektrische Widerstand von der Polarisationsrlchtung In der ferroelektrischen Schicht abhängt und zum Auslesen des Speicherelements Mittel zur Messung des elektrischen Widerstands vorhanden sind,
**dadurch gekennzeichnet, dass** die nicht-ferroelektrische Schicht (4) ein dotiertes elektrisch leitfählges Oxyd oder einen dotierten Halbleiter aufweist.

4. Speicherelement nach Anspruch 3, **dadurch gekennzeichnet, dass** die nicht-ferroelektrische Schicht (4) dotiertes SrTiO₃ aufweist.

5. Speicherelement nach Anspruch 3 oder 4, **dadurch gekennzeichnet, dass** die nicht-ferroelektrische Schicht (4) wenigstens 1 Ångström (0,1 nm) dick ist.

6. Speicherelement nach Anspruch 5, **dadurch gekennzeichnet, dass** die nicht-ferroelektrische Schicht (4) wenigstens 1 Nanometer (1 nm) dick ist.

7. Speicherelement nach einem der Ansprüche 3 bis 6, **dadurch gekennzeichnet, dass** die ferroelektrische Schicht (3) wenigstens 1 Nanometer (1 nm) dick ist.

8. Speicherelement nach Anspruch 7, **dadurch gekennzeichnet, dass** die ferroelektrische Schicht (3) wenigstens 10 Nanometer (10 nm) dick ist.

9. Speicherelement nach einem der Ansprüche 3 bis 8, **dadurch gekennzeichnet, dass** die ferroelektrische Schicht (3) und die nicht-ferroelektrische Schicht (4) zusammen nicht dicker als 5 µm (5000 nm) sind.

10. Speicherelement nach Anspruch 9, **dadurch gekennzeichnet, dass** die ferroelektrische Schicht (3) und die nicht-ferroelektrische Schicht (4) zusammen nicht dicker als 500 nm sind.

## Claims

1. A method for the electronic memorization of information, in which a memory element composed of an electrode (2), a ferroelectric layer (3) adjacent to this one, a layer (4) made of non-ferroelectric material adjacent to the ferroelectric layer (3) as well as an electrode (5) adjacent to the layer (4) made of non-ferroectric material is used for writing an information item into the ferroelectric layer by aligning the polariation of the ferroelectric layer and the information item is read by determining the polarization direction by means of resistance measuring, **characterized in that** the non-ferroelectric layer (4) comprises a doped electrically conductive oxide or a doped semiconductor.

2. A method according to claim 1, **characterized in that** the non-ferroelectric layer (4) of the memory element comprises doped SrTiO₃.

3. A memory element for carrying out the method according to one of the claims 1 or 2, comprising an electrode (2), a ferroelectric layer (3) adjacent to this one, a layer (4) made of non-ferroelectric material adjacent to the ferroelectric layer (3) as well as an electrode (5) adjacent to the non-ferroelectric layer (4), wherein the electric resistance that is by the non-ferroelectric and the ferroelectric layers depends on the polarization direction in the ferroelectric layer and means for measuring the electric resistance are provided for reading out the memory element,
**characterized in that** the non-ferroelectric layer (4) comprises a doped electrically conductive oxide or a doped semiconductor.

4. A memory element according to claim 3, **characterized in that** the non-ferroelectric layer (4) comprises doped SrTiO₃.

5. A memory element according to claims 3 or 4, **characterized in that** the non-ferroelectric layer (4) has got a thickness of at least 1 Ängström (0.1 mm).

6. A memory element according to claim 5, **characterized in that** the non-ferroelectric layer (4) has got a thickness of at least 1 nanometer (1nm).

7. A memory element according to one of the claims 3 through 6, **characterized in that** the ferroelectric layer (3) has got a thickness of at least 1 nanaometer (1 nm).

8. A memory element according to claim 7, **characterized in that** the ferroelectric layer (3) has got a thickness of at least 10 nanometers (10nm).

9. A memory element according to one of the claims 3 through 8, **characterized in that** the ferroelectric layer (3) and the non-ferroelectric layer (4) together have got a thickness of no more than 5 µm (5000 nm).

10. A memory element according to claim 9, **characterized in that** the ferroelectric layer (3) and the non-ferroelectric layer (4) together have got a thickness of no more than 500 nm.

## Revendications

1. Procédé de mémorisation électronique des informations, dans lequel on utilise un élément de mémorisation composé d'une électrode (2), d'une couche ferroélectrique (3) adjacente à celle-ci, d'une couche (4) en matière non ferroélectrique adjacente à la couche ferroélectrique (3) ainsi que d'une électrode (5) adjacente à la couche (4) non ferroélectrique pour inscrire une information dans la couche ferroélectrique par orientation de la polarisation de la couche ferroélectrique et on lit l'information par détermination de la direction de polarisation à l'aide d'une mesure de la résistance, **caractérisé en ce que** la couche non-ferroélectrique (4) comprend un oxyde électriquement conducteur dopé ou un semi-conducteur dopé.

2. Procédé selon la revendication 1, **caractérisé en ce que** la couche non-ferroélectrique (4) de l'élément de mémorisation comprend SrTiO₃ dopé.

3. Elément de mémorisation pour éxécuter le procédé selon l'une des revendications 1 ou 2 comprenant une électrode (2), une couche ferroélectrique (3) adjacente à celle-ci, une couche (4) en matière non ferroélectrique adjacente à la couche ferroélectrique (3) ainsi qu'une électrode (5) adjacente à la couche (4) non ferroélectrique, dans lequel la résistance électrique formée par la couche non-ferroélectrique et la couche ferroélectrique dépend de la direction de polarisation dans la couche ferroélectrique et il y a des moyens de mesure de la résistance électrique pour lire l'élément de mémorisation,
**caractérisé en ce que** la couche non-ferroélectrique (4) comprend un oxyde électriquement conducteur dopé ou un semi-conducteur dopé.

4. Elément de mémorisation selonla revendication 3, **caractérisé en ce que** la couche non-ferroélectrique (4) comprend SrTiO₃ dopé.

5. Elément de mémorisation selon la revendication 3 ou la revendication 4, **caractérisé en ce que** l'épaisseur de la couche non-ferroélectrique (4) est au moins 1 Ängström (0,1 nm).

6. Elément de mémorisation selon la revendication 5, **caractérisé en ce que** l'épaisseur de la couche non-ferroélectrique (4) est au moins 1 nanomètre (1nm).

7. Elément de mémorisation selon l'une des revendications 3 à 6, **caractérisé en ce que** l'épaisseur de la couche ferroélectrique (3) est au moins 1 nanomètre (1 nm).

8. Elément de mémorisation selon la revendication 7, **caractérisé en ce que** l'épaisseur de la couche ferroélectrique (3) est au moins 10 nanomètres (10 nm).

9. Elément de mémorisation selon l'une des revendications 3 à 8, **caractérisé en ce que** les épaisseurs de la couche ferroélectrique (3) et de la couche non-ferroélectrique (4) ensemble ne dépassent pas 5 µm (5000 nm).

10. Elément de mémorisation selon la revendication 9, **caractérisé en ce que** les épaisseurs de la couche ferroélectrique (3) et de la couche non-ferroélectrique (4) ensemble ne dépassent pas 500 nm.
